Europäisches Patentamt

European Patent Office

Office européen des brevets

(11) Numéro de publication: **0 619 610 A1**

## (12) DEMANDE DE BREVET EUROPEEN

(21) Numéro de dépôt: **94200878.0**

(22) Date de dépôt: **30.03.94**

(51) Int. Cl.⁵: **H01L 29/08,** H01L 29/73

(30) Priorité: **07.04.93 FR 9304136**

(43) Date de publication de la demande:
**12.10.94 Bulletin 94/41**

(84) Etats contractants désignés:
**DE FR GB IT NL**

(71) Demandeur: **PHILIPS COMPOSANTS**
**4, rue du Port aux Vins**
**F-92150 Suresnes (FR)**
㉜ **FR**

(71) Demandeur: **N.V. Philips'**
**Gloeilampenfabrieken**
**Groenewoudseweg 1**
**NL-5621 BA Eindhoven (NL)**
㉜ **DE GB IT NL**

(72) Inventeur: **Leduc, Pierre**
**Société Civile S.P.I.D.,**
**156, Boulevard Haussmann**
**F-75008 Paris (FR)**

(74) Mandataire: **Lottin, Claudine et al**
**Société Civile S.P.I.D.**
**156, Boulevard Haussmann**
**F-75008 Paris (FR)**

(54) **Dispositif semiconducteur comprenant un transistor latéral.**

㊼ Dispositif semiconducteur comprenant un transistor bipolaire latéral, par exemple du type PNP, ayant, dans une couche épitaxiale N (3) formée en surface d'un substrat P (1), une région d'émetteur P (15,16) et une région de collecteur P (17), espacées latéralement par une région de base N (19), ce transistor comprenant en outre une couche enterrée $N^{++}$ (18).

Dans ce transistor latéral, le gain en courant est très fortement augmenté, lorsque l'émetteur est formé d'unedite première région partielle d'émetteur faiblement dopée P, s'étendant sous une couche isolante (6) et d'unedite seconde région partielle d'émetteur (16) fortement dopée $P^{++}$ s'étendant sous la zone de contact d'émetteur (26) délimitée par une ouverture dans la couche isolante (6). Les épaisseurs et les dopages respectifs des première (15) et seconde (16) régions d'émetteur sont prévus pour que la première région soit transparente aux électrons et la seconde forme un écran pour les électrons. De plus, le rapport des aires des deux régions partielles (Sox/Sm) est supérieur à 2, l'aire (Sm) de la seconde région (16) étant choisie petite. Les diverses régions du transistor sont formées de couches très minces. Le transistor peut aussi être NPN.

FIG.1B

L'invention concerne un dispositif semiconducteur comprenant un transistor latéral, ce dispositif comportant un substrat semiconducteur d'un premier type de conductivité ayant à sa surface une couche épitaxiale d'un deuxième type de conductivité opposé au premier, couche dans laquelle est délimité, par des régions d'isolement d'épaisseur au moins égale à celle de ladite couche, undit caisson pour former le transistor latéral, lequel présente :

- des régions d'émetteur et de collecteur du premier type de conductivité, espacées latéralement par une région de la couche épitaxiale formant la base du transistor,
- au moins unedite zone de contact électrique d'emetteur pour un plot métallique de contact électrique délimitée par une ouverture en surface de la région d'émetteur dans une couche isolante couvrant la surface du dispositif,
- une couche enterrée, du deuxième type de conductivité disposée au niveau de la jonction substrat-couche épitaxiale,
  et transistor latéral dans lequel en outre :
- le rapport entre l'aire de la région d'émetteur sous la couche isolante, dite première région partielle d'émetteur, et l'aire de la région d'émetteur sous le plot métallique, délimitée par ladite zone de contact électrique d'émetteur, dite seconde région partielle d'émetteur, est au moins égal à 2.

L'invention trouve son application dans tout circuit intégré comprenant des transistors bipolaires latéraux, dans lesquels on recherche un gain en courant élevé.

Dans l'exposé qui suit, par porteurs minoritaires, il faut entendre les électrons lorsque la région considérée est de type P, et il faut entendre les trous lorsque la région considérée est de type N.

Un dispositif semiconducteur comprenant un transistor latéral muni des caractéristiques citées plus haut est déjà connu de l'état de la technique par le brevet européen EP 032 2962. Selon le document cité, le gain en courant des transistors latéraux est limité du fait de leur structure.

Le document cité préconise alors de réaliser la région d'émetteur avec un rapport des aires de la région sous oxyde et de la région de contact électrique qui est compris entre 20 et 200, ce qui permet de favoriser le courant de trous par rapport au courant d'électrons dans la région sous oxyde, et donc d'augmenter le gain du transistor.

Puis, d'une manière étonnante, le gain en courant de ce transistor connu est encore amélioré si la région d'émetteur a une forme allongée selon une direction longitudinale, le rapport entre la grande et la petite dimension d'émetteur étant au moins égal à 5. De cette manière le dispositif connu de la demande EP 032 2962 peut atteindre un gain en courant de l'ordre de 25 à 89.

Ce dispositif a le désavantage d'être très encombrant. Or, dans l'état actuel de la technologie, il est principalement recherché d'augmenter considérablement la densité d'intégration des éléments actifs et passifs sur un même substrat. Cette condition est un impératif absolu de l'industrie des semiconducteurs.

Alors que le dispositif connu du document cité a des performances de gain attractives, en revanche ses dimensions le font écarter du développement industriel des circuits à très haute densité d'intégration.

Cependant, les transistors latéraux sont importants pour la réalisation de circuits intégrés, dans lesquels le concepteur désire insérer des transistors inverseurs avec des transistors source de courant. Dans ce cas, le plus souvent, les transistors inverseurs sont réalisés par des transistors latéraux, et les transistors source de courant par des transistors verticaux.

Il est bien connu de l'homme du métier que les gains en courant des transistors latéraux sont nettement moins grands que ceux des transistors verticaux. Les performances du transistor connu de la demande de brevet EP 032 2962 seraient donc très attractives pour compenser cette différence de gain, n'étaient ses dimensions.

Néanmoins, ce dispositif connu de l'état de la technique marque un tournant dans la technologie des transistors bipolaires latéraux, car son fonctionnement repose sur des effets de surface totalement inconnus de l'état de la technique en vigueur jusque là, et correspond à des théories totalement nouvelles et en complet désaccord avec les théories sur lesquelles reposait l'état de la technique précédemment en usage.

Pour comprendre la nouvelle théorie appliquée dans ce brevet EP 0322962, l'homme du métier lira avec profit la publication intitulée "The Physics and Modeling of Heavily Doped Emitters" par Jesus A. del ALAMO et Richard M. SWANSON dans IEEE Transactions on Electron Devices, Vol.ED-31, N°12, December 1984, pp. 1878-1888. Par émetteurs fortement dopés, il faut entendre à l'époque de la publication des émetteurs plus dopés que les transistors dits LEC (de l'anglais LOW EMITTER CONCENTRATION), c'est-à-dire dopés à environ $10^{18}$ à $10^{20}$ cm$^{-3}$ pour des transistors à couche d'émetteur épaisse entre 2 et 10 $\mu$m. De cette publication, il ressort que le fonctionnement des émetteurs fortement dopés des transistors à couches épaisses est gouverné par le transport et la recombinaison des porteurs minoritaires, mais que les mécanismes affectant le temps de vie des porteurs minoritaires dans le silicium sont extrêmement complexes et doivent faire l'objet de recherches extensives. Cette publication indique encore que, dans de nombreux cas, les résultats expérimentaux sont en contradiction avec les résultats de modélisation. Ceci provient du fait que, à cause de la complexité des phénomènes en jeu, la modélisation ne peut prendre en compte tous les paramètres. Seules des recherches poussées peuvent venir à bout du problème relatif au comportement et au temps de recombinaison des porteurs minoritaires dans le silicium, dans les émetteurs des transistors.

Cependant, cette publication établit que ce comportement dépend du dopage et de l'épaisseur de la couche d' émetteur. Et le dispositif décrit dans la demande EP-0322962 réalise une sélection de moyens mettant en oeuvre cet enseignement de la publication IEEE citée pour fournir la structure de transistor bipolaire latéral ayant un gain amélioré déjà décrit. Ainsi, avec l'apparition de la nouvelle théorie mise en application dans ce brevet EP 032 2962 présentant un émetteur de surface entre 20 et 200 fois plus étendue qu'il n'était d'usage dans les dispositifs conventionnels et une zone de contact extrêmement petite, l'homme du métier se voyait dans l'obligation de reconsidérer sérieusement tout ce qui faisait le fondement de ses connaissances générales antérieures, avec toutes les difficultés annoncées dans la publication IEEE.

C'est pourquoi, il apparaissait jusqu'à ce jour particulièrement difficile d'améliorer le dispositif décrit dans le brevet EP 032 2962 : alors même qu'il était impératif pour son utilisation industrielle dans les circuits LSI (Large Scale Integration en anglais) à grande densité d'intégration, ou VLSI (Very Large Scale Integration) à très grande densité d'intégration, de réduire considérablement ses dimensions, tout en préservant la qualité très précieuse de gain hautement amélioré.

Or il se trouve que loin d'apporter une aide à l'homme du métier, des nouvelles conditions imposées par l'évolution des technologies, ont au contraire renforcé la difficulté de résoudre ce problème. Ces nouvelles conditions sont issues d'un tournant technologique récent qui consiste à réaliser les couches, épitaxiales et implantées, avec des épaisseurs environ 2 à 10 fois plus faibles que ce qui était le cas dans la demande de brevet EP 0322962 précitée, conduisant à des épaisseurs de couche épitaxiale pour la base, de l'ordre de 1 $\mu$m, couche dans laquelle sont formées les régions d'émetteur et de collecteur avec des épaisseurs également faibles. Du fait de cette évolution, il est apparu que le gain des transistors latéraux diminuait corrélativement à la réduction d'épaisseur des couches utilisées. Ainsi, de nouveau, les connaissances générales de l'homme du métier étaient remises en cause, et son expérience acquise dans la compréhension des phénomènes liés aux émetteurs des transistors devait être reconsidérée sur ces bases nouvelles, du fait que les anciennes théories liées aux transistors à couches épaisses n'étaient plus directement applicables.

Le problème technique se pose donc maintenant de manière urgente, de réaliser un dispositif à transistor latéral, compatible avec les nouvelles technologies à couches très minces, de faible surface compatible avec l'intégration à grande échelle et présentant un gain en courant amélioré par rapport à l'état de la technique, alors que ces conditions regroupées semblent particulièrement contradictoires.

Selon l'invention, ce problème est néanmoins résolu au moyen du dispositif dont les éléments sont définis dans le préambule et en outre caractérisé en ce que :

- la couche épitaxiale est du type dit mince ou ultramince, ainsi que les régions réalisées dans cette couche épitaxiale,
- la première région partielle d'émetteur à unedite première épaisseur h1 et undit premier niveau du premier type de conductivité obtenu par un premier taux de dopage tels que la longueur de diffusion des porteurs minoritaires injectés verticalement dans cette première région partielle, est supérieure ou égale à cette épaisseur ;
- la seconde région partielle d'émetteur a une seconde épaisseur h2 de valeur au moins moitié de ladite première épaisseur h1, et undit second niveau du premier type de conductivité plus élevé que le premier, ce second niveau étant obtenu par un second taux de dopage plus élevé que le premier, cette seconde épaisseur et ce second taux étant choisis tels que cette seconde région partielle constitue un écran pour les porteurs minoritaires.
- la première région partielle entoure complètement la seconde région partielle et éventuellement la partie inférieure de cette dernière dans le cas où h2 < h1.

Avec ce dispositif semiconducteur, on obtient l'avantage que le gain en courant du transistor latéral est très nettement amélioré, et que les dimensions en terme d'encombrement sur le substrat sont diminuées. Par exemple, le gain en courant peut être de l'ordre de 50 avec un transistor ayant un émetteur environ 10 fois moins encombrant que le transitor connu du EP 032 2962, ou bien un gain plus que doublé pour un même encombrement d'émetteur, et ceci avec une technologie de couches minces conformes aux nouveaux objectifs.

L'effet produit par les nouveaux moyens techniques appliqués à l'émetteur du transistor est d'autant plus efficace que les couches formant le transistor sont minces. Non seulement cet effet permet de compenser complètement l'effet néfaste produit sur le gain par l'utilisation de la technologie à couches minces, mais encore le gain est d'autant mieux amélioré que les couches sont plus minces.

L'invention est décrite ci-après en détail, en référence avec les figures schématiques annexées, dont :

- la FIG.1A montre, vue du dessus, schématiquement, une partie d'un dispositif semiconducteur comprenant un transistor bipolaire latéral ;
- la FIG. 1B est une vue en coupe selon B-B du transistor bipolaire latéral de la FIG. 1A ;
- la FIG.2 est une représentation symbolique, appliquée à une coupe schématique d'une région d'émetteur d'un transistor bipolaire latéral, des participations des densités de courant dans les différentes parties de la région d'émetteur ;
- la FIG.3 montre des courbes comparatives du gain en courant $h_{FE}$, en fonction du rapport des surfaces d'émetteur sous la couche isolante Sox et d'émetteur sous contact électrique Sm, Sox/Sm ;
- les FIG.4A et 4B montrent des courbes représentatives des taux de dopage [C] en fonction de la profondeur h à partir de la surface dans la région d'émetteur, sous la couche isolante pour la FIG.4A et sous la zone de contact électrique pour la FIG.4B.

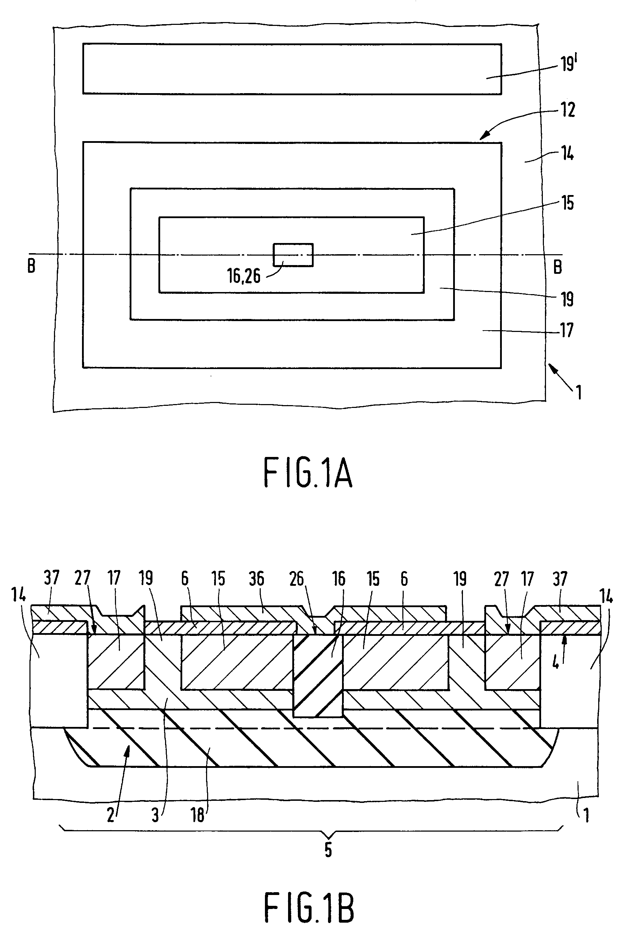

La FIG.1A montre vue du dessus, schématiquement, une partie d'un dispositif semiconducteur comprenant un transistor bipolaire latéral dans un exemple de mise en oeuvre de l'invention et la FIG.1B montre une coupe selon B-B de cette partie du dispositif.

En référence avec les FIG. 1, dans cet exemple de réalisation, ce dispositif comporte un corps semiconducteur 1, par exemple un substrat en silicium (Si) d'un premier type de conductivité P, à la surface 2 duquel est appliquée une couche semiconductrice épitaxiale 3 du type de conductivité opposé N. Cette couche épitaxiale N est subdivisée en plusieurs parties, parmi lesquelles au moins un caisson 5, du deuxième type de conductivité N, au moyen de régions d'isolation 14, ces régions d'isolation 14 s'étendant sur toute l'épaisseur de la couche épitaxiale 3 depuis la surface 4 de cette couche jusqu'au substrat 1.

Le caisson 5 comporte un transistor bipolaire latéral, ayant une région d'émetteur 15, 16 et une région de collecteur 17 séparée l'une de l'autre latéralement par une partie 19 de la couche épitaxiale 3, cette partie 19 formant la base du transistor latéral. Dans cet exemple, le transistor latéral est de type P-N-P.

Une couche enterrée 18 du deuxième type de conductivité, donc N dans l'exemple décrit, est disposée au niveau de la jonction substrat 1-couche épitaxiale 3, dans les limites du caisson 5 formées par les régions d'isolation 14.

En surface respectivement de la région de collecteur 17 et de la région d'émetteur 15,16 sont aménagées desdites zones de contact électrique de collecteur 27 et d'émetteur 26.

Ces zones de contact électriques 26 et 27 sont délimitées par des ouvertures dans une couche isolante 6 couvrant l'ensemble du dispositif. Des plots de contact métalliques 36,37 d'émetteur et collecteur sont respectivement réalisés au-dessus de ces ouvertures, mais ne sont réellement en contact avec le matériau semiconducteur que dans les ouvertures 26,27 respectivement.

La région d'émetteur est constituée de deux régions partielles d'émetteur. La première région partielle d'émetteur 15 a pour épaisseur une valeur h1, par exemple égale à l'épaisseur de la région de collecteur 17. Une condition essentielle est appliquée à la valeur de l'épaisseur h1 et au niveau de conductivité, c'est-à-dire au niveau de dopage de cette première région partielle 15 : la valeur de l'épaisseur h1 et le niveau de conductivité doivent être tels que la longueur de diffusion des porteurs minoritaires, ici des électrons, injectés dans cette région partielle d'émetteur est supérieure à ladite épaisseur h1. Cela revient à dire que ladite première zone partielle 15 doit être transparente pour les porteurs minoritaires injectés. Ceci est obtenu d'une part au moyen d'une épaisseur h1 faible correspondant à une région d'émetteur du genre superficiel tout à fait compatible avec la technologie des transistors latéraux. Ceci est obtenu d'autre part avec une telle première région partielle d'émetteur en outre peu dopée, du premier type de conductivité avec un premier niveau faible, c'est-à-dire dans le cas exemplifié habituellement noté par l'homme du métier P ou P+.

La région 17 de collecteur ayant la même épaisseur h1 faible que la première région partielle 15 d'émetteur, peut être réalisée au cours de la même étape de procédé d'élaboration du dispositif semiconducteur. Dans ce cas, la région 17 de collecteur est également du premier type de conductivité et du premier niveau P ou P+. Du fait de l'épaisseur faible de la région de collecteur, la tension de claquage collecteur-base est élevée.

La région d'émetteur comprend en outre une deuxième région partielle 16 d'émetteur, d'aire moins grande et d'épaisseur h2 qui peut aller d'une valeur moitié de, à une valeur plus grande que celle de la première région partielle d'émetteur 15. Du fait que la première région partielle d'émetteur 15 a une aire plus grande que la seconde, et est réalisée en même temps que la région de collecteur, la distance collecteur-émetteur peut être contrôlée efficacement.

De préférence, l'épaisseur h2 est telle que la seconde région partielle d'émetteur 16 s'étend depuis la surface 4 de la région d'émetteur jusqu'à la couche enterrée 18, sous la zone de contact électrique d'émetteur 26. De plus cette seconde région partielle d'émetteur est du premier type de conductivité, avec un second niveau de ce type de conductivité plus élevé que le premier niveau de la première région partielle. Un tel niveau élevé du premier type de conductivité est noté $P^{++}$ par l'homme du métier dans l'exemple décrit.

Ainsi cette seconde région partielle très dopée s'étend sous le contact métallique d'émetteur 36, spécialement sous la zone 26 où ce dernier est réellement en contact avec la région d'émetteur.

Si la deuxième région partielle d'émetteur est une région profonde, c'est-à-dire atteignant la couche enterrée 18, elle peut être réalisée au cours de la même étape du procédé de réalisation que celle qui permet la formation de régions de contact électrique avec le substrat, et qui est une étape habituelle dans la réalisation des dispositifs intégrés. Sa réalisation n'introduit donc pas d'étape supplémentaire dans l'élaboration du dispositif semiconducteur.

La région de base du transistor latéral est constituée par la couche épitaxiale 3 dans le caisson 5, du second type de conductivité, cette couche étant réalisée à un premier niveau noté N de ce deuxième type de conductivité. La région de base comprend en outre la couche enterrée 18 également du deuxième type de conductivité, à un deuxième niveau plus élevé que le premier niveau de ce deuxième type de conductivité, noté $N^+$. Ainsi la couche enterrée 18 présente une résistivité plus basse que la couche épitaxiale 3. Une condition très favorable à l'invention est que la couche épitaxiale 3 soit mince : typiquement inférieure à 2 $\mu$m, et de préférence inférieure à 1 $\mu$m.

Dans le caisson 5, est aménagée une région superficielle de base 19', à basse valeur ohmique du second type de conductivité $N^+$, pour recevoir un contact de base, dans une zone de contact délimitée par une ouverture dans la couche isolante 6 en surface de cette région 19'. La région 19' est isolée des autres régions par une région d'isolation 12 semblable aux régions 14.

On appellera ci-après la première région partielle d'émetteur : région périphérique 15, et on appellera la seconde région partielle d'émetteur : région centrale 16.

Il est important de noter qu'avec les épaisseurs en jeu dans les nouvelles technologies, les épaisseurs h1 et h2 des deux régions d'émetteur sont toujours très peu différentes.

D'autre part, du fait de ces faibles épaisseurs en jeu, aussi bien la région 15 que la région 16, même si elles sont réalisées d'égale épaisseur h1 = h2, sont très proches de la couche enterrée 18. Ces régions 15 et 16 se différencient avant tout par leur taux de dopage et leur surface respective.

Des dimensions et taux de dopage seront donnés ultérieurement à titre d'exemples non limitatifs.

Selon l'invention, la zone de contact électrique d'émetteur 26 a à peu près la même aire que la seconde région partielle centrale d'émetteur 16, et cette aire est faible devant l'aire de la première région partielle périphérique d'émetteur 15. Le rapport de l'aire de la première région partielle périphérique d'émetteur 15 sur l'aire de la zone de contact d'émetteur 26 est supérieur à 2.

Il est important de noter que la région d'émetteur ne peut pas être constituée de la seule deuxième région partielle centrale d'émetteur 16. L'association des deux régions partielles d'émetteur 15, 16 avec les caractéristiques décrites plus haut est essentielle pour arriver aux but de l'invention. La région d'émetteur ne peut pas non plus se suffire d'une deuxième région fortement dopée entourée d'une première région débordant très faiblement autour de la deuxième région ; ou bien encore entourée de la première région seulement dans une direction latérale. La première région partielle périphérique la moins dopée doit entourer totalement latéralement la seconde région partielle centrale la plus dopée avec les rapports des aires cités plus haut, et éventuellement s'étendre sous cette deuxième région partielle, si h2 < h1.

Par contre, de préférence, la seconde région partielle fortement dopée peut s'étendre jusqu'à la couche enterrée 18 et donc favorablement déborder la première région partielle moins dopée dans la direction verticale.

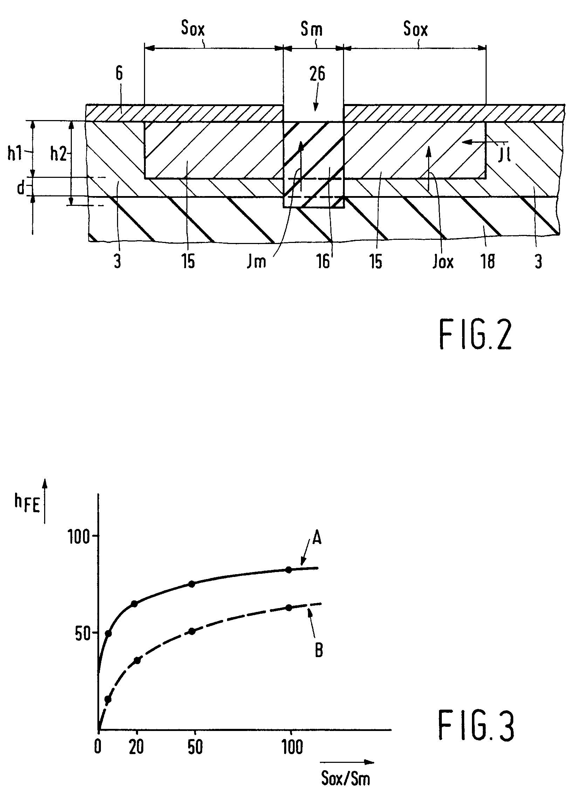

Une étude expérimentale appropriée à vérifier certaines hypothèses théoriques sur les propriétés de l'injection des porteurs dans l'émetteur a permis d'aboutir à un modèle d'injection simplifié, qui est explicité ci-après en référence avec la FIG. 2.

La FIG.2 montre schématiquement une région d'émetteur 15,16 de type P réalisée dans une couche épitaxiale 3 de type N formant la couche de base. Une couche isolante de protection 6, est réalisée en surface du dispositif, et montre une ouverture 26 pour un plot de contact métallique 36 d'émetteur. Le plot de contact métallique 36 est réellement en contact avec la région d'émetteur 15,16 uniquement dans l'ouverture 26 qui a pour aire Sm. La région d'émetteur sous la couche isolante, dite première région partielle d'émetteur 15, ou encore région périphérique d'émetteur, a pour aire Sox. Cette aire Sox comprend l'aire totale de la région d'émetteur 15,16 de laquelle on exclut l'aire Sm de la région sous le contact d'émetteur, c'est-à-dire l'aire de la région centrale d'émetteur 16, ou seconde région partielle d'émetteur, correspondant à l'aire de l'ouverture 26.

La région périphérique d'émetteur 15 a unedite première épaisseur h1 et un niveau de dopage tel que la longueur de diffusion des porteurs minotaires injectés verticalement dans celle-ci est supérieure ou égale à l'épaisseur de cette région. Dans cette couche de type P, les porteurs minoritaires sont les électrons qui partent de la couche enterrée et qui se dirigent vers la surface de la région d'émetteur. Les trous se propagent en sens inverse.

Si le transistor latéral est du type N-P-N au lieu d'être du type P-N-P comme dans l'exemple décrit, alors les porteurs minoritaires sont les trous au lieu d'être les électrons, mais le fonctionnement du transistor est soumis aux mêmes lois théoriques, en remplaçant simplement "électrons" par "trous" dans l'exposé théorique.

On désigne par $J\ell$ la densité de courant d'injection latérale des porteurs minoritaires dans la base 3, par Jm la densité de courant d'injection verticale des porteurs minoritaires sous la zone de contact d'émetteur 16, et par Jox la densité de courant d'injection verticale des porteurs minoritaires sous la portion de couche d'oxyde 6 qui recouvre la région périphérique d'émetteur 15. Les densités de courant d'injection sont représentées par des flèches sur la FIG. 2.

La théorie et l'expérience ont montré que l'expression du gain en courant $h_{FE}$ pouvait s'exprimer en première approximation par :

$$h_{FE} = (K. J\ell. P1. h_1) / (Jm.Sm + Jox.Sox)$$

où P1 est le périmètre de la région périphérique d'émetteur 15, où h1 est son épaisseur et où K est une constante.

Selon l'invention, on augmente le gain en courant $h_{FE}$ lorsque la grandeur Sm est faible, lorsque la grandeur P1 est importante, et en réduisant davantage le terme JmSm par la réduction du terme Jm de densité de courant des porteurs minoritaires.

Cet effet est obtenu grâce aux moyens constitués par :

- le choix de l'aire Sox de la région périphérique d'émetteur 15 et de l'aire Sm de la zone de contact d'émetteur 26 pour obtenir un rapport Sox/Sm environ égal ou supérieur à 2 : et de préférence égal ou supérieur à 5.
- l'existence de la deuxième région partielle d'émetteur 16 de l'aire Sm sensiblement délimitée par la zone 26 de contact d'émetteur, ayant une épaisseur h2 au moins moitié de l'épaisseur h1 de la première région, et de préférence telle que cette deuxième région atteint la couche enterrée 18 ; et qui présente un deuxième niveau de conductivité, supérieur audit premier niveau de conductivité de la région partielle périphérique 15, ce deuxième niveau étant noté $P^{++}$ dans l'exemple décrit, obtenu par un taux de dopage au moins double de celui de la première région d'émetteur. L'épaisseur h2 et le taux de dopage de la région centrale d'émetteur sont choisis tels que cette région centrale 16 constitue un écran pour les porteurs minoritaires.

La nouvelle valeur de la densité de courant Jm sous le contact, dans la région 16, est plus petite d'un facteur environ 3, que la valeur de la densité de courant quand la région 16 n'est pas plus dopée que la région 15.

Le gain en courant est maintenant pratiquement uniquement la conséquence de l'injection latérale.

Cet effet est optimisé si la région superficielle d'émetteur présente une forme allongée selon au moins une direction longitudinale, le rapport entre la plus grande dimension longitudinale et la plus petite dimension transversale étant favorablement de l'ordre de 5 ou plus.

Sur la FIG. 1A, la forme allongée de l'émetteur en même temps qu'une zone de contact d'émetteur de surface limitée permet de mettre pleinement à profit ce phénomène d'injection sous la couche isolante. Selon l'invention, avec la réalisation de la région périphérique d'émetteur 15 faiblement dopée, et avec la réalisation de la région centrale d'émetteur 16 fortement dopée et de l'aire limitée à celle de la zone de contact 26, on a différencié le rôle des participations de ces régions et on a optimisé le fonctionnement du transistor latéral.

La théorie relative à l'augmentation du gain dans un transistor selon l'invention tient compte à la fois du taux de recombinaison des porteurs minoritaires et de leur longueur de diffusion.

Selon l'invention, pour augmenter le gain en courant du transistor, on prévilégie et en renforce les courants de trous par rapport aux courants d'électrons dans la direction verticale. Ce choix permet de minimiser le taux de recombinaison électrons-trous. Cette théorie est en accord avec la théorie de l'efficacité d'injection décrite dans la publication IEEE citée plus haut.

Par longueur de diffusion d'un porteur minoritaire, il faut entendre la distance moyenne parcourue par un porteur minoritaire dans un matériau donné, avant qu'il ne se recombine.

Par taux de recombinaison, il faut entendre le nombre de recombinaisons qui se produisent dans un volume donné par unité de temps. Le taux de recombinaison est une constante dont la valeur dépend de la géométrie du matériau, c'est-à-dire de son épaisseur et de son dopage.

Sous le contact métallique d'émetteur, dans le transistor latéral, si l'émetteur est faiblement dopé, le taux de recombinaison est très élevé du fait que le matériau est quasiment métallique et le courant d'électrons est toujours très élevé. Selon l'invention, on choisit donc de réaliser une zone de contact d'émetteur d'aire très petite Sm pour minimiser le courant d'électrons ; et en même temps, on réalise une région partielle 16 très dopée.

Sous la couche isolante, le taux de recombinaison est faible. On choisit en outre le dopage et l'épaisseur de manière à ce que la longueur de diffusion soit supérieure à l'épaisseur h1 de la région périphérique d'émetteur. Ainsi, en adoptant une aire Sox, importante, on favorise le courant de trous dans cette région. Ce résultat est obtenu avec un dopage P relativement faible et une épaisseur h1 également faible. C'est une des raisons pour laquelle, la technologie mettant en oeuvre des transistors à couches minces ou ultraminces est favorable à l'invention.

De la théorie reposant sur l'efficacité d'injection, il ressort que plus la couche centrale 16 est dopée par rapport à la couche périphérique 15 d'émetteur, plus le courant de trous est renforcé par rapport au courant d'électrons. Ce qui fait que la couche centrale très dopée 16 n'est pas un moyen supplémentaire pour minimiser la recombinaison électrons-trous, mais que cette couche centrale très dopée 16 vient coopérer avec la couche périphérique peu dopée 15 pour renforcer le courant de trous par rapport au courant d'électrons.

En effet, lorsque l'on augmente la différence de taux de dopage entre les régions 15 et 16, on crée entre les deux régions 15 et 16 un profil d'impuretés abrupt. Dans la pente du profil de dopage, il se crée un champ qui est répulsif pour les porteurs minoritaires, ici les électrons, et ainsi on favorise les trous.

Du fait de l'existence de la région centrale 16 très dopée, il est également favorable que les couches soient minces, c'est-à-dire que la distance d entre le bas de la région 16 très dopée (voir la FIG.2) et le haut de la couche 18 de type $N^+$ soit très petite. Cependant, dans le cas actuel de couches ultraminces, vu les dimensions en jeu, la possibilité de réaliser des couches 15 et 16 avec des épaisseurs très différentes est subordonnée aux moyens technologiques disponibles, et en fait il n'est pas rédhibitoire que lesdites couches 15 et 16 aient la même épaisseur h1 = h2 pour obtenir l'amélioration de gain escomptée. Selon l'invention, l'utilisation de structures à couches ultraminces est un avantage et non un inconvénient pour le gain, car le mécanisme d'injection sous la couche isolante est favorisé.

En pratique, le gain en courant est limité par la résistance d'émetteur qui, dans le cas de la FIG.

1A, est induite par la longueur d'émetteur.

Il faut donc choisir les dimensions de la zone de contact d'émetteur de manière à concilier un gain élevé avec une résistance d'émetteur acceptable.

Pour obtenir un transistor latéral ayant un courant élevé, on peut réaliser une structure à plusieurs bandes d'émetteur parallèles. Par contre une structure comportant une seule bande d'émetteur est intéressante pour des fonctionnements à plus faible courant dans lesquels on privilégie un fort gain. Chaque bande d'émetteur comporte une région périphérique 15 avec au moins en son centre une zone de contact 26 et une seconde région d'émetteur 16 s'étendant sous la zone de contact 26. Chaque bande d'émetteur peut comporter plusieurs de ces zones de contact 26 espacées selon la plus grande direction de la bande d'émetteur, avec une seconde région d'émetteur 16 s'étendant sous chaque zone de contact 26. Les diverses zones de contact électrique 26 sont alors reliées entre elles par la métallisation 36 formant le plot de contact électrique d'émetteur.

La FIG.3 représente des courbes du gain en courant $h_{FE}$ respectivement en fonction du rapport Sox/Sm. Le gain $h_{FE}$ est défini comme le rapport du courant collecteur au courant de base IC/IB à tension collecteur-base nulle. Les courbes ont été tracées pour une tension base-substrat de 3V, les transistors ayant les caractéristiques préconisées dans le procédé de réalisation décrit plus loin à titre d'exemple. La courbe A en trait plein concerne un transistor latéral avec une région partielle centrale 16 d'émetteur fortement dopée $P^{++}$ différentiée d'une région périphérique d'émetteur 15 moins dopée. La courbe B en trait discontinu concerne un transistor dit "de comparaison" ayant cette région 16 peu dopée P, non différentiée de la région 15, c'est-à-dire avec un émetteur formé d'une seule région uniformément peu dopée P.

Le gain en A est plus élevé. En outre ce gain est d'autant plus élevé que le rapport Sox/Sm augmente.

Un transistor latéral ayant une structure selon l'invention voit son gain $h_{FE}$ tendre vers un maximum qui est de l'ordre de 90.

Comme il ressort de l'étude comparative des courbes A et B de la FIG. 3, le transistor selon l'invention permet d'obtenir, dans certaines conditions, le même gain que le transistor dit de comparaison. Mais ces conditions sont telles que le transistor selon l'invention nécessite, pour obtenir ce gain, une aire Sox beaucoup moins grande que le transistor de comparaison. Par exemple, pour un gain $h_{FE}$ égal à 65, avec le transistor selon l'invention, (Sox/Sm) = 20, alors qu'avec le transistor de comparaison, (Sox/Sm) = 100.

Ou bien encore, pour un même rapport, c'est-à-dire une même aire, le transistor selon l'invention a un gain beaucoup plus élevé. Par exemple pour un rapport (Sox/Sm) = 5, correspondant à un faible encombrement, le transistor selon l'invention a un gain $h_{FE}$ = 50, alors que le transistor de comparaison atteint seulement 15.

Ainsi, dans le transistor selon l'invention, avec un rapport des aires (Sox/Sm) seulement égal à 2, on obtient déjà le gain de 35 à 40, alors que le transistor de comparaison n'a pratiquement pas de gain avec ces dimensions.

Ceci est obtenu en outre sans effet néfaste secondaire relatif à la tension de claquage.

Le transistor selon l'invention représente donc un progrès considérable par rapport à l'état de la technique.

Le transistor a été décrit du type latéral PNP, mais rien ne s'oppose à ce qu'il soit du type NPN, selon toute structure NPN généralement connue de l'homme du métier. Dans un tel transistor latéral NPN, les deux régions partielles d'émetteur sont de type N avec les niveaux de conductivité moyen pour la région périphérique et fort pour la région centrale comme indiqué précédemment. Le rapport des surfaces Sox/Sm est aussi le même.

On décrit ci-après, à titre d'exemple non limitatif, un procédé de réalisation du dispositif représenté sur les FIG.1A et 1B.

Dans une partie d'une surface 2 d'un substrat 1 en silicium de type P, d'épaisseur environ 120 $\mu$m, ayant un taux de dopage d'environ $5.10^{15}$ cm$^{-3}$ et une résistivité environ 3 $\Omega$.cm, est réalisée une implantation d'impuretés appropriées à produire une conductivité de type N, pour former ultérieurement, par diffusion, la couche enterrée N$^+$ 18 de type N$^+$. Ensuite, est réalisée de façon usuelle une couche épitaxiale 3 de silicium de type N d'une épaisseur pouvant être inférieure à 1 $\mu$m, ou pouvant aller jusqu'à 2 $\mu$m, ayant un taux de dopage d'environ $2.10^{16}$ cm$^{-3}$ et une résistivité de l'ordre de 0,3 $\Omega$.cm. Une couche épitaxiale ayant une épaisseur dans la fourchette indiquée est considérée comme mince ou ultramince par l'homme du métier. A ce stade, on réalise la diffusion de l'impureté de type N pour former la couche enterrée 18, d'épaisseur de l'ordre de 1 $\mu$m, ayant un taux de dopage N$^+$ environ $2.10^{19}$.cm$^{-3}$.

La couche épitaxiale 3 peut être obtenue de type N par dopage à l'arsenic (As). La couche épitaxiale 3 forme la région de base. Dans le transistor dont les courbes de gain sont données FIG.3, la couche épitaxiale avait une épaisseur de 1,25 $\mu$m.

Les zones séparatrices 12, 14 peuvent être réalisées au moyen de caissons d'isolement en oxyde de silicium SiO$_2$ (oxyde profond).

La région partielle périphérique 15 d'émetteur peut être réalisée au centre de la région de base, par l'implantation puis diffusion d'une impureté telle que le bore (B) permettant d'obtenir la conductivité P, au moyen d'un masque ayant une ouverture de grande surface. Dans l'exemple décrit, le taux de dopage maximal est de l'ordre de $5.10^{18}$.cm$^{-3}$, l'épaisseur h1 de l'ordre de 0,7 $\mu$m, et la résistance par carré de l'ordre de 500 $\Omega$. Avec ces valeurs, la première région partielle d'émetteur est transparente pour les porteurs minoritaires.

La seconde région partielle centrale 16 d'émetteur peut alors être réalisée par implantation puis diffusion d'une impureté telle que le bore (B) permettant d'obtenir la conductivité P$^{++}$ au moyen d'un masque d'ouverture réduite, avec un taux de dopage supérieur à celui de la première diffusion, le taux de dopage maximal dans cet exemple étant $10^{19}$.cm$^{-3}$ ; et sur une épaisseur h2 qui, dans cet exemple, est supérieure à l'épaisseur h1 de la région périphérique et atteint la couche enterrée 18. Par exemple h2 = 1 $\mu$m. Mais, dans d'autres exemples, on peut réaliser h2 de valeur inférieure, par exemple h2 = 0,4 $\mu$m, toutes les autres épaisseurs étant inchangées. Néanmoins, les résultats sur le gain sont meilleurs lorsque h2 > h1. La résistance par carré est, dans cet exemple, de l'ordre de 120 $\Omega$. Avec ces valeurs, la seconde région partielle d'émetteur 16 est un écran pour les porteurs minoritaires.

D'une manière générale l'épaisseur h2 de la région centrale d'émetteur reste dans une fourchette entre la moitié de h1, à très légèrement supérieure à h1. Vu l'épaisseur choisie pour la couche épitaxiale 3, les épaisseurs h1 et h2 sont également considérées comme minces ou ultraminces.

Le rapport entre le dopage de la région centrale d'émetteur et le dopage de la région périphérique est dans une fourchette environ 2 à 10, le dopage de la région périphérique 15 étant lié à l'épaisseur h1 pour que la longueur de diffusion des porteurs minoritaires soit supérieure à h1, et celui de la région centrale étant choisi pour former l'écran souhaité auxdits porteurs minoritaires en coopération avec l'épaisseur h2.

Une couche de protection 6, par exemple en oxyde de silicium (SiO$_2$) ou en nitrure de silicium (Si3N$_4$), est réalisée en surface de l'ensemble du dispositif, avec des ouvertures en surface des zones prévues pour les contacts. L'aire de l'ouverture Sm, ainsi que la région 16 correspondante sont choisies aussi petites que la technologie le permet. Cependant les améliorations apportées par l'invention dues au dopage de la région centrale 16 font que cette condition sur Sm n'est plus aussi contraignante que dans l'état de la technique.

Sachant que l'aire Sm est petite, le transistor selon l'invention n'est donc pas encombrant, et est compatible avec l'intégration à grande échelle.

Sur les FIG.1 et 2, les dimensions des différentes parties sont disproportionnées pour être plus clairement lues.

Si l'homme du métier vient à diminuer l'épaisseur de la couche épitaxiale 3, pour amener cette épaisseur à environ 1 $\mu$m, il gardera de préférence constante l'épaisseur $h_1$ de la région périphérique 15 d'émetteur, à environ 0,7 $\mu$m. Ainsi la distance d diminue, ce qui est favorable à l'invention.

Dans d'autres exemples de mise en oeuvre, l'homme du métier peut réaliser la région périphérique 15, et la région centrale 16 ou zone de contact d'émetteur 26 avec les formes de motifs déjà décrits dans l'état de la technique EP 0322962, en conservant les conditions énoncées dans la présente description.

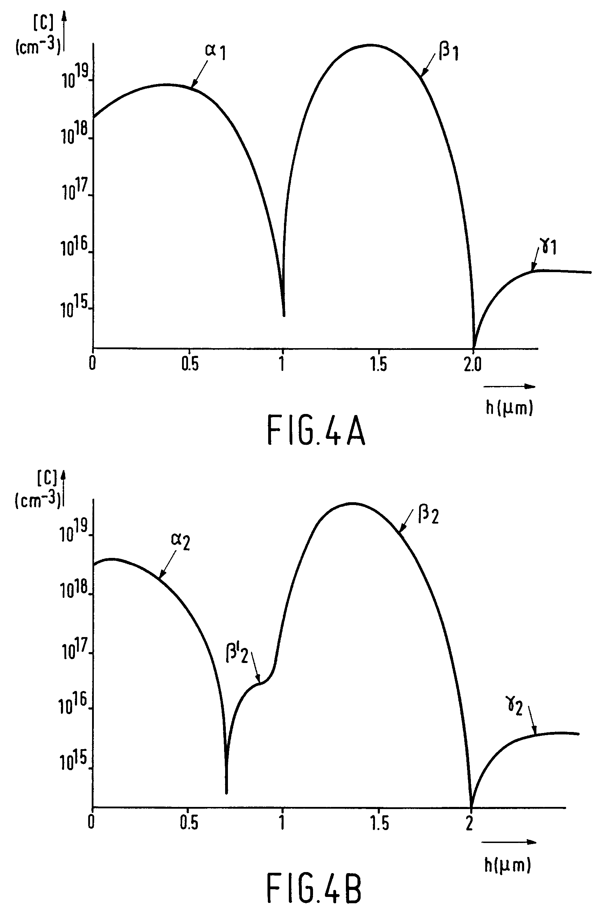

Les FIG. 4A et 4B montrent les profils de dopage des différentes régions en partant de la surface 4 du transistor latéral en allant vers le substrat 1, qui sont conformes au procédé de réalisation qui vient d'être décrit.

La FIG.4A représente le taux de dopage [C] en nombre d'impuretés par cm$^3$ en ordonnée, en fonction de la profondeur h en $\mu$m en abscisse, en coupe verticale à travers la région centrale 16 de l'émetteur sous métal (zone de contact 26).

La partie $\alpha$1 correspond au taux de dopage de type P$^{++}$ ($10^{19}$ cm$^{-3}$) dans la région centrale d'émetteur 16 sous métal qui s'étend sur une épaisseur de 1 $\mu$m, la partie $\beta$1 correspond au taux de dopage N$^+$ de la couche enterrée 18 située entre 1 et 2 $\mu$m de base sous l'émetteur, et la partie $\gamma$1 correspond au taux de dopage du substrat de type P ($5.10^{15}$. cm$^{-3}$).

La FIG. 4B représente le taux de dopage [C] en nombre d'impuretés par cm$^3$ en ordonnée, en fonction de la profondeur h en $\mu$m en abscisse, en coupe verticale à travers la région périphérique 15 d'émetteur sous oxyde (couche isolante 6).

La partie $\alpha$2 correspond au taux de dopage de type P ($5.10^{18}$.cm$^{-3}$) dans la région d'émetteur 15 s'étendant directement sous l'oxyde sur une épaisseur de 0,7 $\mu$m : la partie $\beta$'2 correspond au taux de dopage de la partie de couche épitaxiale 3 disposée entre la région d'émetteur 15 et la couche enterrée 18 : la partie $\beta$2 correspond au taux de dopage de type N$^+$ de la couche enterrée 18 située entre 1 et 2 $\mu$m ; et la partie $\gamma$2 correspond au taux de dopage du substrat de type P ($5.10^{15}$.cm$^{-3}$).

Ces courbes ont été tracées pour une épaisseur de couche épitaxiale 3 de 1,25 $\mu$m.

## Revendications

1.  Dispositif semiconducteur comprenant un transistor latéral, ce dispositif comportant un substrat semiconducteur (1) d'un premier type de conductivité ayant à sa surface une couche épitaxiale d'un deuxième type de conductivité opposé au premier, couche dans laquelle est délimité, par des régions d'isolement d'épaisseur au moins égale à celle de ladite couche, undit caisson pour former le transistor latéral, lequel présente :
    - des régions d'émetteur (15,16) et de collecteur (17) du premier type de conductivité, espacées latéralement par une région (19) de la couche épitaxiale formant la base du transistor,
    - au moins unedite zone de contact électrique d'emetteur (26) pour un plot métallique (36) de contact électrique délimitée par une ouverture en surface de la région d'émetteur dans une couche isolante (6) couvrant la surface du dispositif,
    - une couche enterrée (18), du deuxième type de conductivité disposée au niveau de la jonction (2) substrat-couche épitaxiale,
    et transistor latéral dans lequel en outre :
    - le rapport entre l'aire (Sox) de la région d'émetteur sous la couche isolante, dite première région partielle d'émetteur (15), et l'aire (Sm) de la région d'émetteur sous le plot métallique, délimitée par ladite zone de contact électrique d'émetteur, dite seconde région partielle d'émetteur (16), est au moins égal à 2,
    **caractérisé en ce que :**
    - la couche épitaxiale est du type dit mince ou ultramince, ainsi que les régions réalisées dans cette couche épitaxiale,
    - la première région partielle d'émetteur (15) à unedite première épaisseur h1 et undit premier niveau du premier type de conductivité obtenu par un premier taux de dopage tels que la longueur de diffusion des porteurs minoritaires injectés verticalement dans cette première région partielle, est supérieure ou égale à cette épaisseur,
    - la seconde région partielle d'émetteur (16) a une seconde épaisseur h2 de valeur supérieure à la moitié de ladite première épaisseur h1, et undit second niveau du premier type de conductivité plus élevé que le premier, ce second niveau étant obtenu par un second taux de dopage plus élevé que le premier, cette seconde épaisseur et ce second taux étant choisis tels que cette seconde région partielle constitue un écran pour les porteurs minoritaires,

- la première région partielle (15) entoure complètement la seconde région partielle (16) et éventuellement la partie inférieure de cette dernière dans le cas où h2 < h1.

2. Dispositif selon la revendication 1, caractérisé en ce que la valeur de l'épaisseur h2 de la seconde région partielle d'émetteur (16) est telle que cette seconde région partielle (16) s'étend jusque dans la couche enterrée (18).

3. Dispositif selon l'une des revendications 1 ou 2, caractérisé en ce que le rapport entre l'aire (Sox) de la première région partielle d'émetteur et l'aire (Sm) de la seconde région partielle d'émetteur est compris entre 2 et 100.

4. Dispositif selon la revendication 3, caractérisé en ce que le rapport entre l'aire (Sox) de la première région partielle d'émetteur et l'aire (Sm) de la seconde région partielle d'émetteur est compris entre 2 et 10.

5. Dispositif selon l'une des revendications 1 à 4, caractérisé en ce que l'aire de la seconde région d'émetteur et l'aire de la zone de contact qui sont sensiblement égales, sont aussi peut étendues que la technologie de réalisation le permet.

6. Dispositif selon l'une des revendications 1 à 5, caractérisé en ce que la région d'émetteur (15,16) présente une forme allongée selon au moins une direction longitudinale formant une bande comprenant une première région partielle (15) et au moins une seconde région partielle d'émetteur (16) s'étendant sous une zone de contact d'émetteur (26) reliée au plot métallique de contact (36), le rapport entre la plus grande dimension longitudinale et la plus petite dimension transversale de la première région partielle d'émetteur (15) étant au moins égal à 5.

7. Dispositif selon la revendication 6, caractérisé en ce que, la région d'émetteur est constituée de plusieurs bandes allongées parallèles, ayant chacune une première région partielle d'émetteur (15), et au moins une seconde région partielle d'émetteur (16) s'étendant sous une zone de contact d'émetteur (26), chaque zone de contact d'émetteur étant reliée au plot métallique (36).

8. Dispositif selon l'une des revendication 6 ou 7, caractérisé en ce que chaque bande d'émetteur comporte à l'intérieur de la première région partielle (15), plusieurs secondes régions partielles (16) espacées selon la dimension longitudinale de la bande, et s'étendant chacune sous une zone de contact d'émetteur (26), reliée au plot métallique (36).

9. Dispositif selon l'une des revendications 1 à 8, caractérisé en ce que le rapport entre le taux de dopage de la seconde région partielle (16) d'émetteur la plus dopée, et le taux de dopage de la première région partielle (15) d'émetteur est au moins égal à 2.

FIG.1A

FIG.1B

FIG.2

FIG.3

FIG.4A

FIG.4B

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | EP-A-0 228 748 (RTC COMPELEC)<br>* abstract; figure 3A *<br>--- | 1 | H01L29/08<br>H01L29/73 |
| A | EP-A-0 378 164 (KABUSHIKI KAISHA TOSHIBA)<br>* abstract; figure 1B *<br>--- | 1 | |
| A | EP-A-0 462 029 (SGS THOMSON MICROELECTRONICS)<br>* abstract; figure 3B *<br>--- | 1 | |
| A | US-A-5 147 809 (WON ET AL.)<br>* abstract; figure 3E *<br>----- | 1 | |
| | | | TECHNICAL FIELDS SEARCHED (Int.Cl.5)<br><br>H01L |

The present search report has been drawn up for all claims

| Place of search | Date of completion of the search | Examiner |
|---|---|---|
| THE HAGUE | 4 July 1994 | Baillet, B |